(19) Europäisches Patentamt
European Patent Office
Office européen des brevets

(11) Publication number: **0 121 394 B1**

# EUROPEAN PATENT SPECIFICATION

(45) Date of publication of patent specification: 23.10.91 (51) Int. Cl.5: **G06F 11/20, G11C 11/40**

(21) Application number: 84302044.7

(22) Date of filing: 27.03.84

(54) Static semiconductor memory device incorporating redundancy memory cells.

(30) Priority: 28.03.83 JP 50347/83
29.03.83 JP 51535/83

(43) Date of publication of application:
10.10.84 Bulletin 84/41

(45) Publication of the grant of the patent:
23.10.91 Bulletin 91/43

(84) Designated Contracting States:
DE FR GB

(56) References cited:
EP-A- 0 095 721
US-A- 4 053 873
US-A- 4 247 921

IEEE JOURNAL OF SOLID-STATE CIRCUITS,
vol. SC-17, no. 5, October 1982, pages
804-809, IEEE, New York, US; Y. UCHIDA et
al.: "A low power resistive load 64 kbit CMOS
RAM"

IEEE JOURNAL OF SOLID-STATE CIRCUITS,
vol. SC-17, no. 5, October 1982, pages
798-803, IEEE, New York, US; K. OCHII et al:
"An ultralow power 8K x 8-bit full CMOS RAM
with a six-transistor cell"

IEEE JOURNAL OF SOLID-STATE CIRCUITS,
vol. SC-16, no. 5, October 1981, pages
435-443, IEEE, New York, US; K.C. HARDEE et
al.: "A fault-tolerant 30 ns/375 mW 16K x 1
NMOS static RAM"

(73) Proprietor: FUJITSU LIMITED
1015, Kamikodanaka Nakahara-ku
Kawasaki-shi Kanagawa 211(JP)

(72) Inventor: Aoyama, Keizo
11-28, Tsukimino 1-chome
Yamato-shi kanagawa 242(JP)
Inventor: Seki, Teruo Dai-2 Yayoi-so 5
5-2, Shimoshinjo 3-chome Nakahara-ku
Kawasaki-shi Kanagawa 211(JP)
Inventor: Yamauchi, Takahiko
No. 10, Aza Maeda 115 Sakuragawa
Mizusawa-shi Iwata 023(JP)

(74) Representative: Sunderland, James Harry et al
HASELTINE LAKE & CO Hazlitt House 28
Southampton Buildings Chancery Lane
London WC2A 1AT(GB)

**Description**

The present invention relates to a static semiconductor memory device incorporating redundancy memory cells.

In a semiconductor memory device, a large number of memory cells are arranged along rows and columns. The density of defects generated in such a semiconductor memory device during the manufacture thereof is relatively independent of the integration density of the device. Rather, it derives from the semiconductor manufacturing technology. In general, the higher the integration density of the device, the greater the ratio of normal memory cells to defective memory cells. This is one of the advantages of increasing the integration density of a semiconductor memory device.

Even if a device includes only one defective memory cell, however, the device cannot be operated normally and, therefore, must be scrapped. As a result, despite the lower ratio of defective memory cells, greater integration density means reduced manufacturing yield.

To overcome the problem of defective memory cells, use is made of redundancy (redundant) memory cells. When a defective memory cell is detected, a redundancy memory cell row or column is selected instead of the memory cell row or column including the defective memory cell. In general, one or two redundancy memory cell rows or columns are usually provided.

A problem in the prior art, however, has been that when the defective memory cell has a direct current (DC) defect, i.e., when the defective memory cell is short-circuited, the DC defect itself is not resolved even when a redundancy memory cell row or column is selected.

An article by Uchida et al in IEEE Journal of Solid-State Circuits, Vol. SC-17, No. 5, October 1982, pp 804-809, discloses a low-power resistive load 64 k bit CMOS RAM having two spare rows of memory cells. Fuse elements are programmed so that a spare decoder selects one of the spare rows instead of a failure row. However, there is no disclosure of the above-mentioned problem of a DC defect, and no measure is taken to resolve such a DC defect.

An article by Ochii et al in the same journal, pp 798-803, discloses an ultralow power 64 k bit CMOS RAM having spare rows and columns of memory cells. The spare rows or columns are again selected by programming fuses, and in addition, fuses are provided for isolating a failure row electrically by cutting the corresponding power line. However, this necessitates replacing both a failure row and its neighbour by a pair of spare rows so as to complete the power isolation. This is wasteful of spare cell capacity.

According to the present invention, there is provided a static semiconductor memory device comprising:

a power supply means;

a memory cell array having a plurality of normal memory cell rows or columns each comprising a plurality of memory cells;

at least one redundancy (redundant) memory cell row or column comprising a plurality of redundancy memory cells, said redundancy memory cell row or column being able to replace one of said normal cell rows or columns including a defective cell;

a plurality of selecting line means, each connected to one of said normal memory cell rows or columns, or to a said redundancy memory cell row or column; and

connecting/disconnecting means to/from said redundancy memory cell row or column each linked between the corresponding selecting line means and said power supply means; and characterised by:

a plurality of connecting/disconnecting means, each linked between one of said selecting line means and said power supply means and operable to temporarily electrically disconnect said selecting line means from said power supply means for at least a non-selected mode of said device, during normal operation thereof; wherein said connecting/disconnecting means comprise transistors linked between said selecting line means and said power supply means, each of said transistors being an enhancement MIS transistor having a drain connected to said power supply means, a source connected to one of said selecting line means, and a gate, the potential of said gate being controlled by pulse generating means comprising an inverter for inverting a chip select signal, so as to turn on and off said MIS transistor.

In an embodiment of the present invention, the potential of a clock signal is applied to loads linked between bit line pairs and a power supply at least during a non-selected state (stand-by state) so as to cut off currents flowing through the loads, thereby reducing the load current of bit lines for all memory cells, including a defective memory cell. That is, even when the defective memory cell has a DC defect, power supply currents due to the DC defect are suppressed thereby substantially resolving the DC defect.

Reference is made, by way of example, to the accompanying drawings, wherein:

Fig. 1 is a block diagram of a prior art static semiconductor memory device;

Fig. 2 is a circuit diagram of the memory cell of Fig. 1;

Fig. 3 is a block diagram of an embodiment of the static semiconductor memory device according to the present invention;

Figs. 4A and 4B are timing diagrams for explaining the clock signal ø in Fig. 3;

Fig. 5 is a logic diagram of a circuit for generating the clock signal ø of Fig. 4B;

Figs. 6A, 6B, and 6C are other timing diagrams for explaining the clock signal ø in Fig. 3;

Fig. 7 is a block circuit diagram of a circuit for generating the clock signal ø in Fig. 6C;

Fig. 8 is a logic circuit diagram of the pulse generating circuit $PG_i$ of Fig. 7; and

Figs. 9A through 9H are timing diagrams of the signals appearing in the circuit of Fig. 8.

Figs. 10 and 11 are block diagrams of semiconductor memory devices useful for explaining the present invention.

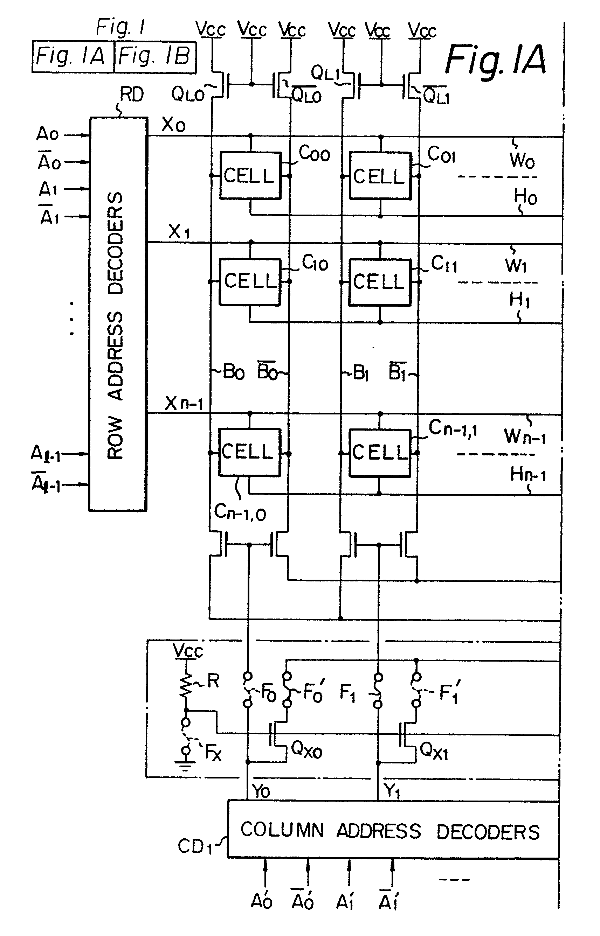

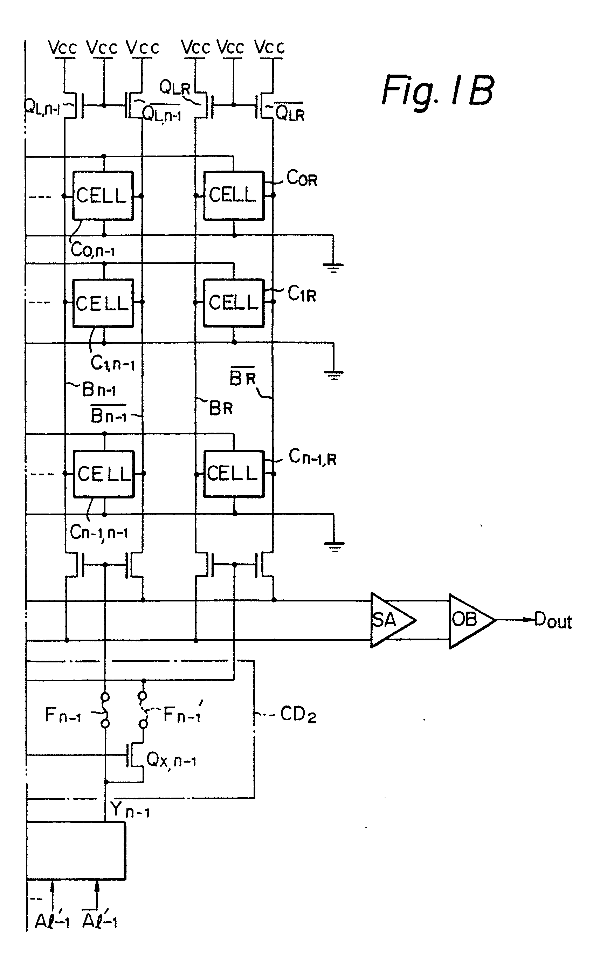

In Fig. 1, which illustrates a prior art static semiconductor memory device, normal static memory cells $C_{ij}$ (i,j = 0, 1, ..., n-1) are arranged in an n-row n-column matrix. Each memory cell is connected to one word line, a hold line and a pair of bit lines. For example, a memory cell $C_{00}$ is connected to a word line $W_0$ , to a hold line $H_0$ , and to bit lines $B_0$ and $\overline{B}_0$. In addition, a series of memory cells $C_{0R}$ , $C_{1R}$ , ..., $C_{n-1,R}$ are arranged along the column direction. These memory cells $C_{0R}$ , $C_{1R}$ , ..., $C_{n-1,R}$ serve as redundancy memory cells.

Selection of the word lines $W_0$ , $W_1$ , ..., $W_{n-1}$ is performed by the row-selection signals $X_0$ , $X_1$ , ..., $X_{n-1}$ of row address decoders RD. That is, the row address decoders RD receive address signals $A_0$ , $\overline{A}_0$ , $A_1$ , $\overline{A}_1$ , ..., $A_{\ell-1}$ , $\overline{A}_{\ell-1}$ from row address buffers (not shown). Accordingly, one of the outputs $X_0$ , $X_1$ , ..., $X_{n-1}$ (n = $2^{\ell}$) of the decoders RD becomes high, whereby one of the word lines is selected. On the other hand, the hold lines $H_0$ , $H_1$ , ..., $H_{n-1}$ are connected to earth, which serves as one of the power supplies. The bit lines $B_0$ , $\overline{B}_0$ , $B_1$ , $\overline{B}_1$ , ..., $B_{n-1}$ , $\overline{B}_{n-1}$ , $B_R$ , and $\overline{B}_R$ are connected via load transistors $Q_{L0}$ , $\overline{Q}_{L0}$ , $Q_{L1}$ , $\overline{Q}_{L1}$ , ..., $Q_{LR}$ , $\overline{Q}_{LR}$ to a power supply $V_{CC}$. The load transistors are, for example, enhancement metal-insulator-semiconductor (MIS) transistors.

Reference $CD_1$ designates column decoders, and $CD_2$ designates a decoder for selecting the redundancy memory cells. The decoder $CD_2$ is comprised of a resistor R, fuses $F_X$ , $F_0$ , $\overline{F}_0$ , $F_1$ , $\overline{F}_1$ , ..., $F_{n-1}$ , $\overline{F}_{n-1}$ , and transistors $Q_{X0}$ , $Q_{X1}$ , ..., $Q_{Xn-1}$. Note, SA is a sense amplifier, OB is an output buffer, $D_{out}$ is output data, and $A_0'$, $\overline{A_0}'$, $A_1'$, $\overline{A_1}'$, ..., $A_{\ell-1}'$ , and $\overline{A_{\ell-1}}'$ are column address signals.

Prior to testing of the device of Fig. 1, all the fuses of the decoder $CD_2$ are in a connected state. Therefore, the gate potentials of the transistors $Q_{X0}$ , $Q_{X1}$ , ..., $Q_{X,n-1}$ are low, and accordingly, these transistors are in an off state. In this state, a test is performed upon the memory cells $C_{ij}$ (i,j = 0, 1, ...,

n-1). If the memory cell $C_{00}$ is determined to be defective, the fuse $F_X$ is melted so as to turn on the transistors $Q_{X0}$ , $Q_{X1}$ , ..., $Q_{Xn-1}$. In addition, the fuses $F_0$ , $F_1'$ , ..., $F_{n-1}'$ are melted. Thus, when the column decoders $CD_1$ generate a column selection signal $Y_0$ for selecting the memory cell $C_{00}$ , the redundancy memory cell $C_{0R}$ instead of the defective memory cell $C_{00}$ is actually selected by the fuse $F_0'$. Note, if no defective memory cell is detected, none of the fuses are melted, and, accordingly, all the fuses are in a connected state. Thus, it is possible to detect (select) a redundancy memory cell instead of a defective memory cell.

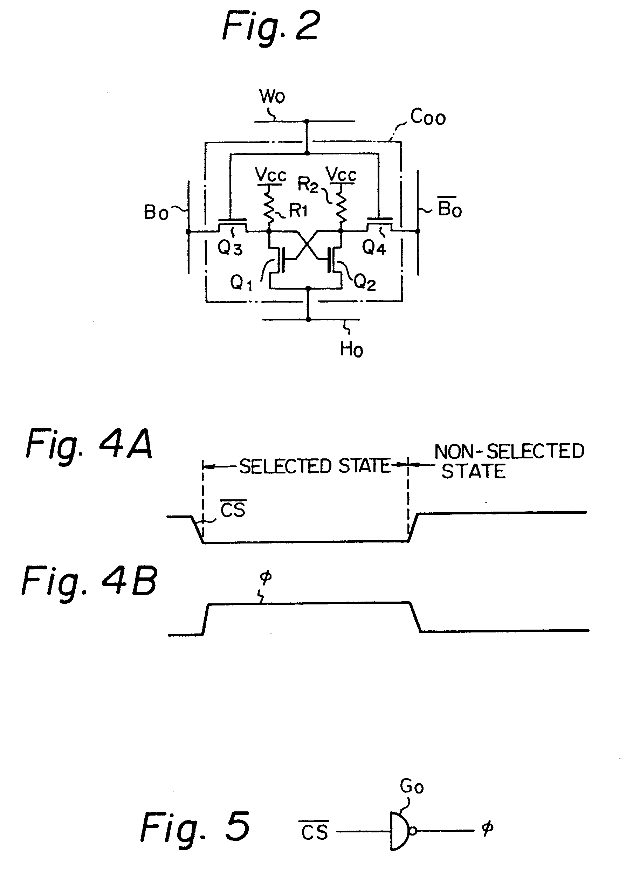

In the device of Fig. 1, however, when a direct current (DC) defect is generated in the interior of a memory cell, the defect itself is not resolved. For example, as illustrated in Fig. 2, the memory cell $C_{00}$ is comprised of resistors $R_1$ and $R_2$ , driver transistors $Q_1$ and $Q_2$ , and transfer transistors $Q_3$ and $Q_4$. Therefore, when a DC defect is generated so as to short-circuit the bit line $B_0$ or $\overline{B}_0$ to the hold line $H_0$ , a current flows from the power supply $V_{CC}$ via the load transistor $Q_L$ and the short-circuited portion to the hold line $H_0$ even when the redundancy memory cell $C_{0R}$ is selected instead of the memory cell $C_{00}$. Therefore, the DC defect itself is not resolved.

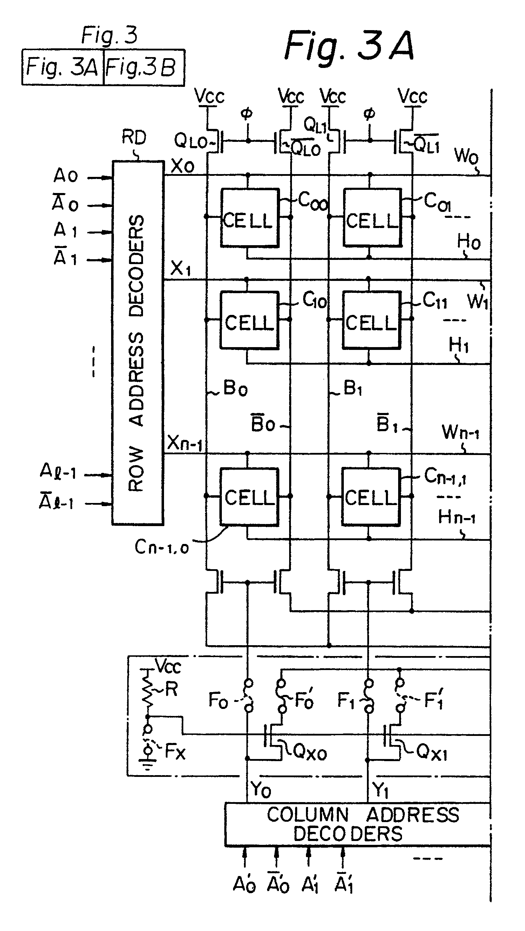

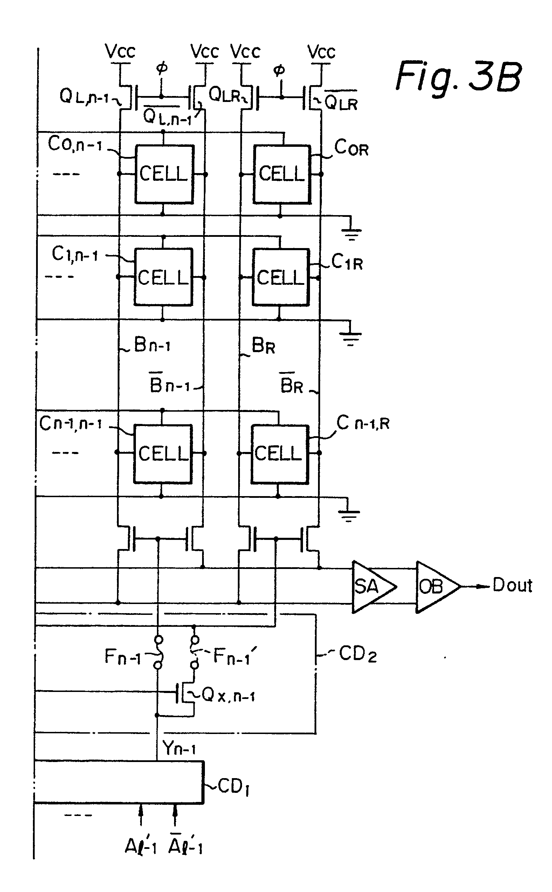

In Fig. 1, note, the power supply voltage $V_{CC}$ is also applied to the gates of the load transistors $Q_{L0}$ , $\overline{Q}_{L0}$ , $Q_{L1}$ , $\overline{Q}_{L1}$ , ..., $Q_{L,n-1}$ , $\overline{Q}_{L,n-1}$ , $Q_{LR}$ , $\overline{Q}_{LR}$. In Fig. 3, which illustrates an embodiment of a first aspect of a static memory device according to the present invention, a clock signal ø is applied to the gates of the transistors $Q_{L0}$ , $\overline{Q}_{L0}$ , $Q_{L1}$ , $\overline{Q}_{L1}$ , ..., $Q_{L,n-1}$ , $\overline{Q}_{L,n-1}$ , $Q_{LR}$ , $\overline{Q}_{LR}$. The potential of the clock signal ø is made low at least during a non-selected state, thereby preventing currents from flowing from the power supply $V_{CC}$ to all the memory cells.

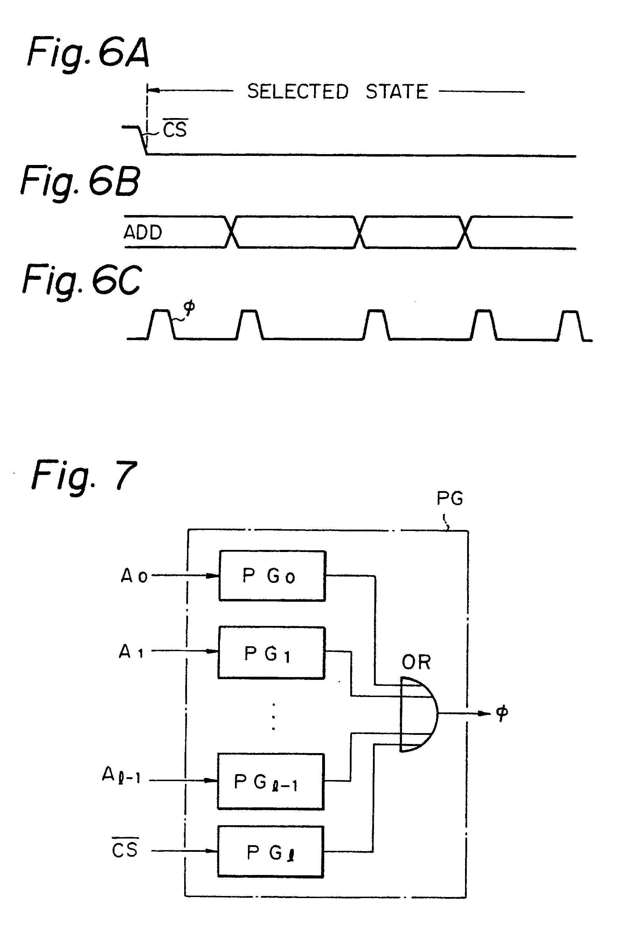

As shown in Figs. 4A and 4B, the above-mentioned clock signal (pulse signal) ø is obtained as an inversion signal of a chip select signal $\overline{CS}$. That is, the clock signal ø is easily obtained by using an inverter $G_0$ as shown in Fig. 5. As a result, even when the above-mentioned DC defect is generated, no short-circuit current due to the DC defect flows during a non-selected state, since the potential of the clock signal ø is, in this case, low, so that all the load transistors are cut off. Note, a current flowing through the defective portion in the case of the potential of the clock signal ø being high is extremely small as compared with the total power consumption of the semiconductor device.

Figures 6A, 6B, and 6C are also timing diagrams for explaining the generation of the clock signal ø of Fig. 3. The clock signal ø as shown in Fig. 6C becomes high for a definite (short) time period only after the chip select signal $\overline{CS}$ as shown in Fig. 6A is changed or after one ADD of the row address signals $A_0$, $A_1$, ..., and $A_{\ell-1}$ is changed. Therefore, the current flowing from the power supply $V_{CC}$ to the above-mentioned defective portion is of shorter duration than with the signal ø as shown in Fig. 4B. Note, the reason why power supply currents due to the conductive load transistors are supplied to the bit lines after the change of the row address signals $A_0$, $A_1$, ..., and $A_{\ell-1}$ is that, when reverse data opposed to the previous read data is read out from the same bit line pair, the bit line pair must be in a precharging (stand-by) state.

The clock signal ø as shown in Fig. 6C can be obtained by a pulse generating circuit PG of Fig. 7. That is, in Fig. 7, the pulse generating circuit PG comprises a plurality of clock pulse generating circuits $PG_0$, $PG_1$, ..., $PG_{\ell-1}$, and $PG_\ell$ corresponding to each of the row address signals $A_0$, $A_1$, ..., $A_{\ell-1}$, and the chip select signal $\overline{CS}$. Therefore, when one of the signals $A_0$, $A_1$, ..., $A_{\ell-1}$, and $\overline{CS}$ is changed, for example, when the signal $A_0$ is changed, the clock pulse generating circuit $PG_0$ generates the clock signal ø via an OR circuit OR. That is, when the device of Fig. 3 is changed from a non-selected state to a selected state or vice versa, or when the selected row is changed, the pulse generating circuit PG generates the clock signal ø.

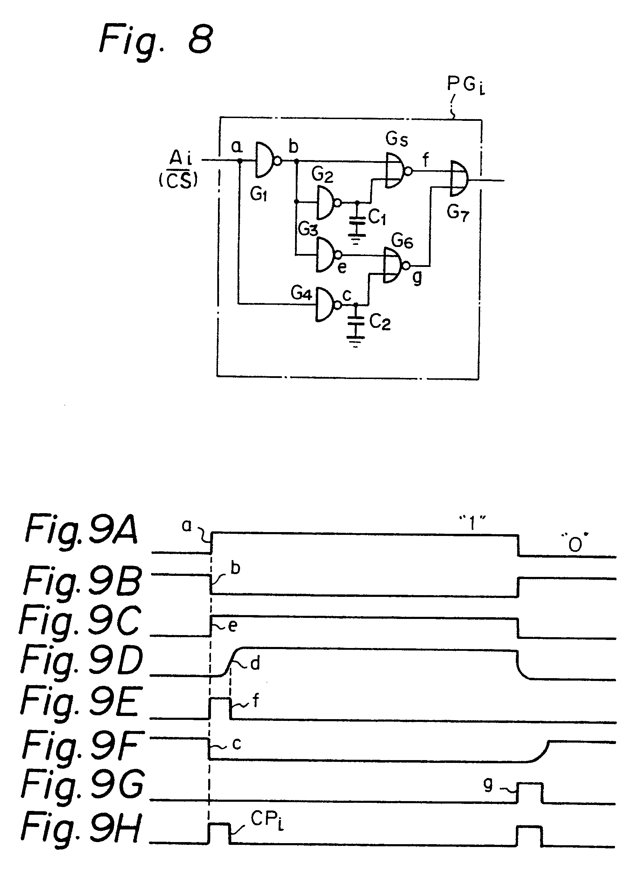

In Fig. 8, which is a detailed logic circuit diagram of one of the clock pulse generating circuits $PG_i$ of the pulse generating circuit PG of Fig. 7, references $G_1$ to $G_4$ are NAND gates, $G_5$ and $G_6$ NOR gates, $G_7$ an OR gate, and $C_1$ and $C_2$ capacitors. Operation will be explained below with reference to Figs. 9A to 9H. When the address signal $A_i$ (node a) is changed from "1" to "0" as shown in Fig. 9A, the output b of the NAND gate $G_1$ changes as shown in Fig. 9B and the output d of the NAND gate $G_2$ is an inverted signal of the signal b which is delayed a little by the capacitor $C_1$, as shown in Fig. 9D. As a result, the output f of the NOR gate $G_5$ is a pulse which is generated by the rise of the address signal $A_i$, as shown in Fig. 9E. Similarly, in the circuit of the NAND gates $G_3$ and $G_4$, the capacitor $C_2$, and the NOR gate $G_6$, the output g of the NOR gate $G_6$ is a signal which is generated by the fall of the address signal $A_i$, as shown in Fig. 9G. Therefore, as shown in Fig. 9H the output $CP_i$ of the OR gate $G_7$, which combines the signal f with the signal g, is a clock signal which is generated by the change of the address signal $A_0$, $A_1$, ..., $A_{\ell-1}$, or the signal $\overline{CS}$.

Thus, since the bit line load currents are reduced in duration, the power supply currents flowing through a defective memory cell can be reduced, even when the defective memory cell has a DC defect. Therefore, the DC defect can be substantially resolved.

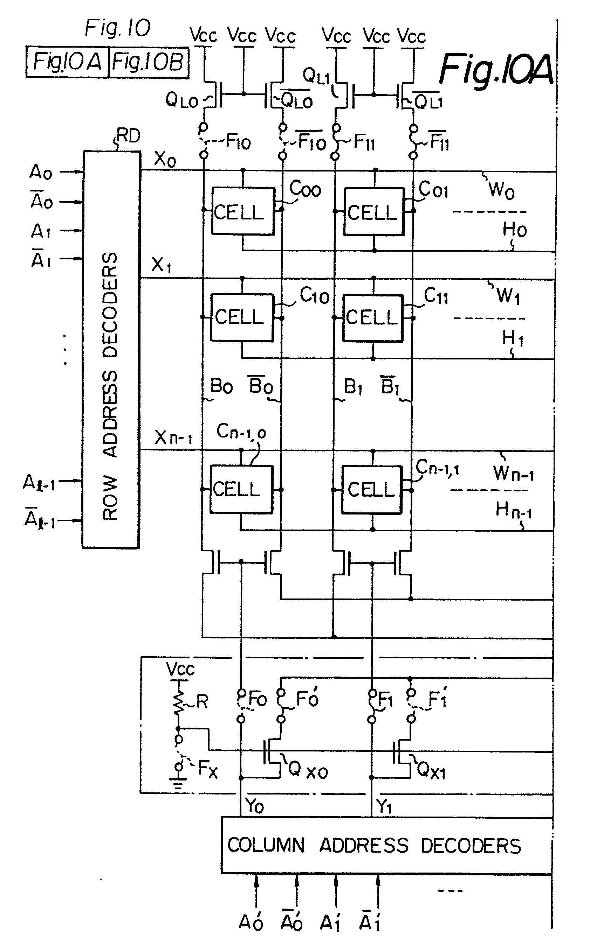

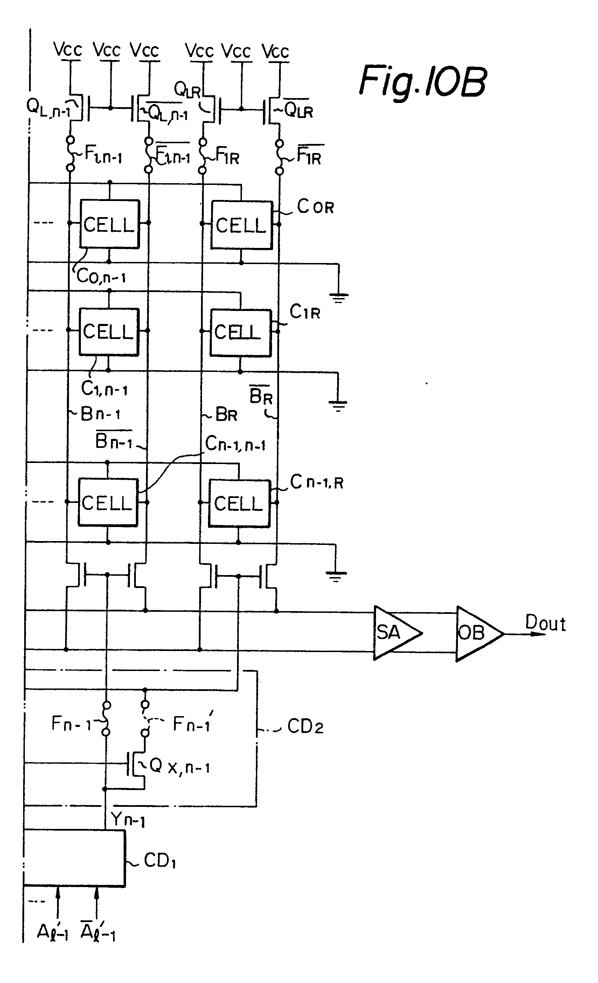

In Fig. 10, which illustrates a semiconductor memory device useful for explaining the present invention, fuses $F_{10}$, $\overline{F}_{10}$, $F_{11}$, $\overline{F}_{11}$, ..., $F_{1,n-1}$, $\overline{F}_{1,n-1}$, $F_{1R}$, and $\overline{F}_{1R}$, are added to the elements of Fig. 1. Each fuse is provided between the memory cells and the power supply $V_{CC}$. Note, each fuse can be provided on the drain side of the load transistor (between drain and $V_{cc}$)as well as on the source side (between source and bit line) thereof. In either case, the same effect is exhibited.

For example, when the memory cell $C_{00}$ is determined to be defective, in the decoder $CD_2$, the fuses $F_X$, $F_0$, $F_1'$, ..., and $F_{n-1}'$ are melted in the same way as stated above. In addition, the fuses $F_{10}$ and $\overline{F}_{10}$ are melted. Therefore, even when the memory cell $C_{00}$ has a DC defect, no current flows from the power supply $V_{CC}$ via the memory cell $C_{00}$ to the hold line $H_0$. This means that the DC defect is completely resolved.

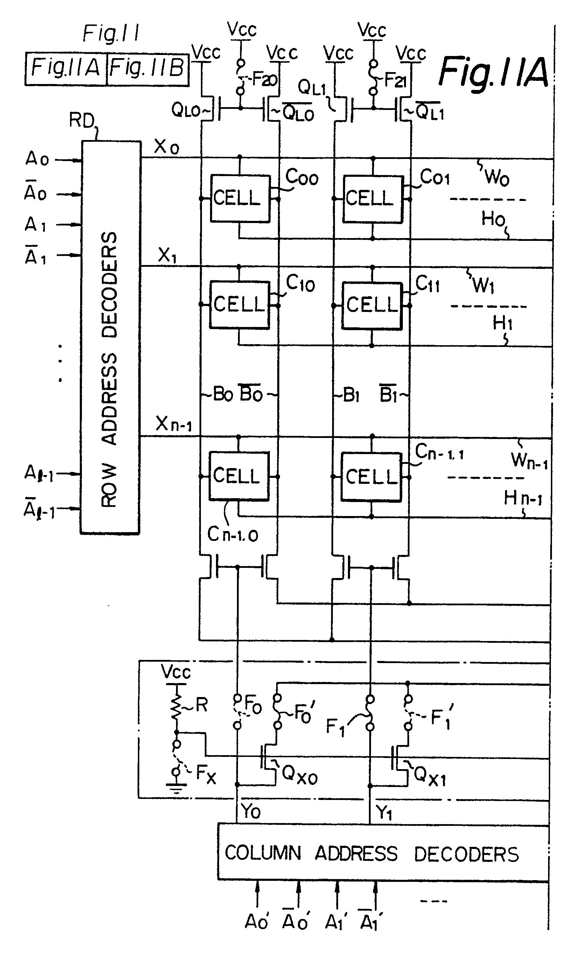

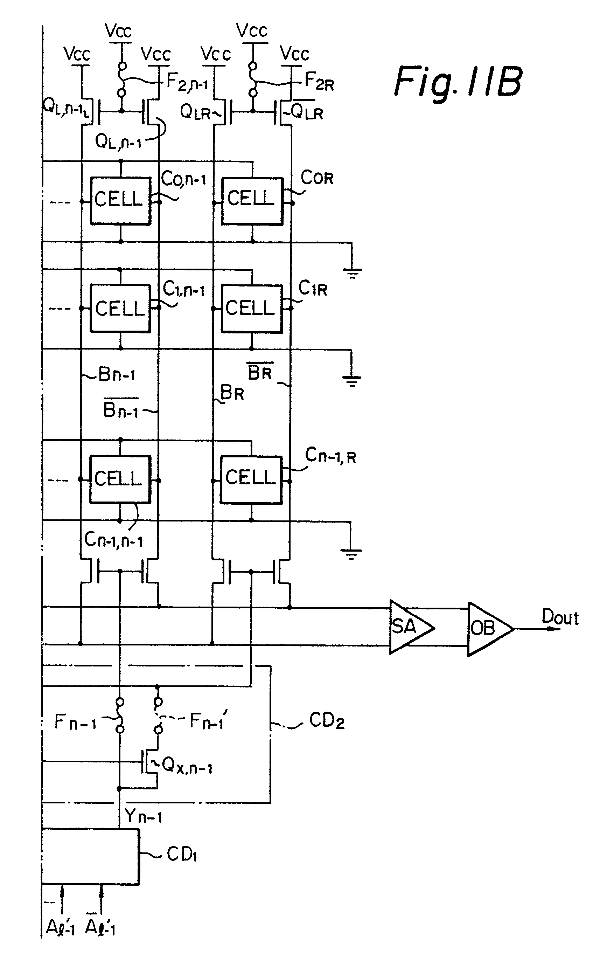

In Fig. 11, which illustrates another semiconductor memory device useful for explaining the present invention, fuses $F_{20}$, $F_{21}$, ..., $F_{2,n-1}$, and $F_{2R}$ are added to the elements of Fig. 1. This case is equivalent to that wherein each fuse is provided between the memory cells and the power supply $V_{CC}$.

For example, when the memory cell $C_{00}$ is determined to be defective, in the decoder $CD_2$, the fuses $F_X$, $F_0$, $F_1'$, ..., and $F_{n-1}'$ are melted in the same way as stated above. In addition, the fuse $F_{20}$ is melted, thereby producing the same result as in the Fig. 10 device.

Thus, since the power supply $V_{CC}$ can be disconnected from a defective memory cell, a DC defect within memory cells is itself resolved.

Note that while the above-mentioned embodiments relate to static metal-oxide semiconductor (MOS) memory devices, the invention can be applied in the same way to other memory devices, such as static bipolar transistor memory devices.

**Claims**

1. A static semiconductor memory device comprising:

a power supply means ($V_{CC}$);

a memory cell array having a plurality of normal memory cell rows or columns comprising ($C_{ij}$; $0 \leq i, j \leq n-1$)

at least one redundancy (redundant) memory cell row or column comprising a plurality of redundancy memory cells ($C_{0R}$, $C_{1R}$, ..., $C_{n-1,R}$), said redundancy memory cell row or column being able to replace one of said normal cell rows or columns including a defective cell;

a plurality of selecting line means ($B_0$, $\overline{B}_0$; $B_1$, $\overline{B}_1$;..., $B_{n-1}$, $\overline{B}_{n-1}$, $B_R$, $\overline{B}_R$), each connected to one of said normal memory cell rows or columns, or to a said redundancy memory cell row or column; and

connecting/disconnecting means ($Q_{LR}, \overline{Q_{LR}}$) to/from said redundancy memory cell row or column each linked between selecting line means ($B_R$, $\overline{B_R}$) and said power supply means ($V_{CC}$); and characterised by:

a plurality of connecting/disconnecting means ($Q_{L0}$, $\overline{Q_{L0}}$; $Q_{L1}$, $\overline{Q_{L1}}$;...; $Q_{L,n-1}$ $\overline{Q_{L,n-1}}$) to/from said normal memory cell rows or columns, each linked between one of said selecting line means ($B_0$, $\overline{B_0}$;...; $B_{n-1}$, $\overline{B_{n-1}}$) and said power supply means ($V_{CC}$) and operable to temporarily electrically disconnect said selecting line means ($B_0$, $\overline{B_0}$;...; $B_{n-1}$, $\overline{B_{n-1}}$) from said power supply means ($V_{CC}$) for at least a non-selected mode of said static semidonductor memory device, during normal operation thereof;

wherein said connecting/disconnecting means ($Q_{L0}$, $\overline{Q_{L0}}$;...; $Q_{LN-1}$, $\overline{Q_{LN-1}}$) comprise transistors linked between said selecting line means ($B_0$, $\overline{B_0}$;...$B_{n-1}$, $\overline{B_{n-1}}$) and said power supply means ($V_{CC}$), each of said transistors being an enhancement MIS transistor having a drain connected to said power supply means ($V_{CC}$) a source connected to one of said selecting line means, and a gate, the potential of said gate being controlled by pulse ($\emptyset$) generating circuits ($PG_i$; $i = 0...l$) corresponding to each of the row address signals ($A_i$; $i = 0...l-1$) and an inverted inverting a chip select signal ($\overline{CS}$), so as to turn on and off said MIS transistor.

2. A device as set forth in claim 1, further comprising a plurality of additional selecting line means ($W_0$, $W_1$,...$W_{n-1}$), connected to said memory cells and said redundancy memory cells, said additional selecting line means being perpendicular to said selecting line means ($B_0$, $\overline{B_0}$; $B_1$, $\overline{B_1}$;...; $B_{n-1}$, $\overline{B_{n-1}}$; $B_R$, $\overline{B_R}$).

3. A device as set forth in claim 2, wherein said connecting/disconnecting means ($Q_{L0}$, $\overline{Q_{L0}}$;...;$Q_{L,n-1}$, $\overline{Q_{L,n-1}}$) electrically connects said selecting line means ($B_0$, $\overline{B_0}$;...; $B_{n-1}$, $\overline{B_{n-1}}$)to said power supply means ($V_{CC}$) for a definite time period after said static semiconductor memory device is changed from a non-selected mode to a selected mode or after the potential of one of said additional selecting line means ($W_0$, $W_1$,...; $W_{n-1}$) is changed.

4. A device as set forth in claim 1, 2 or 3, wherein said connecting/disconnecting means $Q_{L0}$, $\overline{Q_{L0}}$;...;$Q_{L,n-1}$, $\overline{Q_{L,n-1}}$; $Q_{LR}$, $\overline{Q_{LR}}$) further comprises:

fuse means ($F_{10}$, $\overline{F_{10}}$,..., $F_{1,n-1}$, $\overline{F_{1,n-1}}$, $F_{1R}$, $\overline{F_{1R}}$) linked between said selecting line means and said transistors; and

a melting means for melting said fuse means connectable to one of said selecting line means ( $B_0$, $\overline{B_0}$;..;$B_{n-1}$,$\overline{B_{n-1}}$) connected to one or more defective memory cells.

5. A device as set forth in claim 1, 2 or 3, wherein said connecting/disconnecting means ($Q_{L0}$, $\overline{Q_{L0}}$;...; $Q_{L,n-1}$, $\overline{Q_{L,n-1}}$, $Q_{LR}$, $\overline{Q_{LR}}$) further comprises:

fuse means ($F_{20}$ , $\overline{F_{21}}$,..., $F_{2,n-1}$, $F_{2R}$)linked between said power supply means ($V_{CC}$)and said transistors; and

a melting means for melting said fuse means connectable to one of said selecting line means ($B_0$, $\overline{B_0}$;...;$B_{n-1}$,$\overline{B_{n-1}}$) connected to one or more defective memory cells.

6. A device as set forth in any preceding claim, wherein each of said selecting line means ($B_0$, $\overline{B_0}$;$B_1$, $\overline{B_1}$;...;$B_{n-1}$, $\overline{B_{n-1}}$; $B_R$, $\overline{B_R}$) comprises a pair of bit lines.

**Revendications**

1. Dispositif mémoire semi- conducteur statique comprenant :

des moyens d'alimentation électrique ($V_{CC}$) ;

une matrice de cellules mémoire présentant une pluralité de colonnes et de rangées de cellules mémoire normales ($C_{ij}$ ; $0 \leq i$; $j \leq n-1$)

au moins une colonne ou une rangée de cellules mémoire de redondance ou redondantes, comprenant une pluralité de cellules mémoire de redondance ($C_{0R}$, $C_{1R}$, ..., $C_{n-1,R}$), la dite colonne ou rangée de cellules mémoire de redondance étant prévue pour remplacer l'une des dites colonnes ou rangées de cellules normales comprenant une cellule défectueuse ou en panne ;

un pluralité de moyens de sélection de ligne ($B_0$, $\overline{B_0}$; $B_1$, $\overline{B_1}$; ...; $B_{n-1}$, $\overline{B_{n-1}}$), $B_R$, $\overline{B_R}$), chacun connecté à l'une des dites rangées ou colonnes de cellules mémoire normales, ou à une dite colonne ou rangée de cellules mémoire de redondance ; et

des moyens de connexion et de déconnexion ($Q_{LR}$, $\overline{Q_{LR}}$ depuis/ vers la dite rangée ou colonne de cellules mémoire redondantes, chacun relié entre les moyens de sélection de ligne ($B_R$, $\overline{B_R}$) et les dits moyens d'alimentation électrique ($V_{CC}$) ;

et caractérisé par :

une pluralité de moyens de connexion ou de déconnexion ($Q_{L0}$, $\overline{Q_{L0}}$; $Q_{L1}$, $Q_{L1}$, ..., $Q_{L,n-1}$, $\overline{Q_{L,n-1}}$) depuis/vers les dites rangées ou colonnes de cellules mémoire normales, chacun relié entre un des dits moyens de sélection de ligne ($B_0$, $\overline{B_0}$; ...; $B_{n-1}$, $\overline{B_{n-1}}$) et les dits moyens d'alimentation électrique ($V_{CC}$) et pouvant fonctionner de façon à déconnecter électriquement temporairement les dits moyens de sélection de ligne ($B_0$, $\overline{B_0}$; ...; $B_{n-1}$, $\overline{B_{n-1}}$) des dits moyens d'alimentation électrique ($V_{CC}$) pour au moins un mode non sélectionné du dit dispositif mémoire statique semi- conducteur, durant son fonctionnement normal ;

dispositif mémoire semiconducteur statique dans lequel les dits moyens de connexion ou de déconnexion ($Q_{L0}$, $\overline{Q_{L0}}$, ..., $Q_{L,n-1}$, $\overline{Q_{L,n-1}}$) comprennent des transistors reliés entre les dits moyens de sélection de ligne ($B_0$, $\overline{B_0}$, ..., $B_{n-1}$, $\overline{B_{n-1}}$) et les dits moyens d'alimentation électrique ($V_{CC}$), chacun des dits transistors étant un transistor étant un transistor MIS à enrichissement présentant un drain connecté aux dits moyens d'alimentation électrique ($V_{CC}$), une source connectée à l'un des dits moyens de sélection de ligne, et une porte, le potentiel de la dite porte étant commandé par des circuits générateurs (ø) d'impulsion ($PG_i$ ; i = 0 ... ℓ) correspondant à chacun des signaux d'adresse de rangée ($A_i$ ; i = 0 ... ℓ-1) et à un signal inversé de sélection de puce ($\overline{CS}$), de façon à ouvrir ou à fermer le dit transistor MIS.

2. Dispositif défini comme dans la revendication 1, comprenant de plus une pluralité de moyens additionnels de sélection de ligne ($W_0$, $W_1$, ..., $W_{n-1}$) connectés aux dites cellules mémoire et aux dites cellules mémoire de redondance, les dits moyens additionnels de sélection de ligne étant perpendiculaires aux dits moyens de sélection ligne ($B_0$, $\overline{B_0}$ ; $B_1$, $\overline{B_1}$ ; ...; $B_{n-1}$, $\overline{B_{n-1}}$, $B_R$, $\overline{B_R}$).

3. Dispositif comme défini dans la revendication 2, dans lequel les dits moyens de connexion et de déconnexion ($Q_{L0}$, $\overline{Q_{L0}}$; ..., $Q_{L,n-1}$, $\overline{Q_{L,n-1}}$) connectent électriquement les dits moyens de sélection de ligne ($B_0$, $\overline{B_0}$, ..., $B_{n-1}$, $\overline{B_{n-1}}$) aux dits moyens d'alimentation électrique ($V_{CC}$) pendant une période de temps définie après que le dit dispositif mémoire statique semiconducteur ait changé d'un mode non sélectionné à un mode sélectionné ou après que le potentiel de l'un des dits moyens additionnels de sélection de ligne ($W_0$, $W_1$, ..., $W_{n-1}$) ait changé.

4. Dispositif comme défini dans la revendication 1, 2 ou 3, dans lequel les dits moyens de connexion ou de déconnexion ($Q_{L0}$, $\overline{Q_{L0}}$, ..., $Q_{L,n-1}$, $\overline{Q_{L,n-1}}$, $Q_{LR}$, $\overline{Q_{LR}}$) comprennent de plus :

des moyens servant de fusibles ($F_{10}$, $\overline{F_{10}}$, ..., $F_{1,n-1}$, $\overline{F_{1,n-1}}$, $F_{1R}$, $\overline{F_{1R}}$) reliés entre les dits moyens de sélection de ligne et les dits transistors ; et

des moyens de fusion pour fondre les dits moyens servant de fusibles connectables à l'un des dits moyens de sélection de ligne ($B_0$, $\overline{B_0}$, ..., $B_{n-1}$, $\overline{B_{n-1}}$) connectés à au moins une cellule mémoire défectueuse.

5. Dispositif comme défini dans les revendications 1, 2 ou 3, dans lequel les dits moyens de connexion ou de déconnexion comprennent de plus :

des moyens servant de fusibles ($F_{20}$, $F_{21}$, ..., $F_{2,n-1}$, $F_{2R}$) reliés entre les dits moyens d'alimentation électrique ($V_{CC}$) et les dits transistors ; et

des moyens de fusion pour fondre les dits moyens servant de fusibles connectables à l'un des moyens de sélection de ligne ($B_0$, $\overline{B_0}$, ..., $B_{n-1}$, $\overline{B_{n-1}}$) connecté à au moins une des cellules mémoire défectueuses.

6. Dispositif comme défini dans l'une quelconque des revendications précédentes, dans lequel chacun des dits moyens de sélection de ligne ($B_0$, $\overline{B_0}$, $B_1$, $\overline{B_1}$ ..., $B_{n-1}$, $\overline{B_{n-1}}$, $B_R$, $\overline{B_R}$) comprend une paire de lignes de bit.

**Patentansprüche**

1. Statische Halbleiterspeichervorrichtung mit:
einer Energieversorgungseinrichtung ($V_{CC}$);
einem Speicherzellenarray, das eine Vielzahl von normalen Speicherzellenreihen- oder -spalten ($C_{ij}$; 0≤ i, j ≤ n-1) hat, wenigstens einer (redundanten) RedundanzSpeicherzellenreihe oder -spalte, die eine Vielzahl von Redundanzspeicherzellen ($C_{0R}$, $C_{1R}$, ..., $C_{n-1, R}$) umfaßt, welche Redundanzspeicherzellenreihe oder -spalte eine der genannten normalen Zellenreihen oder -spalten ersetzen kann, die eine defekte Zelle enthält;
einer Vielzahl von Auswahlleitungseinrichtungen ($B_0$, $\overline{B_0}$; $B_1$, $\overline{B_1}$; ...; $B_{n-1}$, $\overline{B_{n-1}}$); $B_R$, $\overline{B_R}$), die jeweils mit einer der genannten Speicherzellenreihen oder -spalten oder mit einer genannten Redundanzspeicherzellenreihe oder -spalte verbunden sind; und
Verbindungs/Trenn-Einrichtungen ($Q_{LR}$, $\overline{Q_{LR}}$) zu/von der genannten Redundanzspeicherzellenreihe oder -spalte, die jeweils zwischen Auswahlleitungseinrichtungen ($B_R$, $\overline{B_R}$) und der genannten Energieversorgungseinrichtung ($V_{CC}$) verbunden sind;

einer Vielzahl von Verbindungs/Trenn-Einrichtungen ($Q_{L0}$, $\overline{Q}_{L0}$; $Q_{L1}$, $\overline{Q}_{L1}$; ... $Q_{L,n-1}$; $\overline{Q}_{L,n-1}$) zu/von den genannten normalen Speicherzellenreihen oder -spalten, die jeweils zwischen einer der genannten Auswahlleitungseinrichtungen ($B_0$, $\overline{B}_0$; ...; $B_{n-1}$, $\overline{B}_{n-1}$) und der genannten Energieversorgungseinrichtung ($V_{CC}$) verbunden und betreibbar sind, um temporär die genannte Auswahlleitungseinrichtung ($B_0$, $\overline{B}_0$; ...; $B_{n-1}$, $\overline{B}_{n-1}$) von der genannten Energieversorgungseinrichtung ($V_{CC}$) zu trennen, für wenigstens einen nicht-ausgewählten Modus der genannten statischen Halbleiterspeichervorrichtung, während des normalen Betriebs derselben;

bei der die genannte Verbindungs/Trenn-Einrichtungen ($Q_{L0}$, $\overline{Q}_{L0}$; ... $Q_{L,n-1}$; $\overline{Q}_{L,n-1}$) Transistoren umfassen, die zwischen der genannten Auswahlleitungseinrichtung ($B_0$, $\overline{B}_0$; ...; $B_{n-1}$, $\overline{B}_{n-1}$) und der genannten Energiever- sorgungseinrichtung ($V_{CC}$) verbunden sind, wobei jeder der genannten Transistoren ein Anreicherungs-MIS-Transistor ist, der ein Drain hat, das mit der genannten Energieversorgungseinrichtung ($V_{CC}$) verbunden ist, eine Source, die mit einer der genannten Auswahlleitungseinrichtungen verbunden ist, und ein Gate, wobei das Potential des genannten Gate durch die genannten Puls-($\emptyset$)-Erzeugungsschaltungen ($PG_i$; $i = 0$ ... $\ell$) gesteuert wird, die jedem der Reihenadreßsignale ($A_i$; $i = 0$ ... $\ell-1$) und einem invertierten Chip-Auswahlsignal ($\overline{CS}$) entsprechen, um so den genannten MIS-Transistor ein- und auszuschalten.

2. Vorrichtung nach Anspruch 1, ferner mit einer Vielzahl von zusätzlichen Auswahlleitungseinrichtungen ($W_0$, $W_1$, ... $W_{n-1}$), die mit den genannten Speicherzellen und den genannten Redundanzspeicherzellen verbunden sind, wobei die genannte zusätzliche Auswahlleitungseinrichtung senkrecht zu der genannten Auswahlleitungseinrichtung ($B_0$, $\overline{B}_0$; ...; $B_{n-1}$, $\overline{B}_{n-1}$, $B_R$, $\overline{B}_R$) ist.

3. Vorrichtung nach Anspruch 2, bei der die genannte Verbindungs/Trenn-Einrichtung ($Q_{L0}$, $\overline{Q}_{L0}$; ... $Q_{L,n-1}$; $\overline{Q}_{L,n-1}$) die genannte Auwahlleitungseinrichtung ($B_0$, $\overline{B}_0$; ...; $B_{n-1}$, $\overline{B}_{n-1}$) mit der genannten Energieversorgungseinrichtung ($V_{CC}$) verbindet, für eine definierte Zeitperiode nachdem die genannte statische Halbleiterspeichervorrichtung von einem nicht-ausgewählten Modus in einen ausgewählten Modus wechselt, oder nachdem das Potential von einer der genannten zusätzlichen Auswahlleitungseinrichtungen ($W_0$, $W_1$, ..., $W_{n-1}$) geändert worden ist.

4. Vorrichtung nach Anspruch 1, 2 oder 3, bei der die genannte Verbindungs/Trenn-Einrichtung ($Q_{L0}$, $\overline{Q}_{L0}$; ... $Q_{L,n-1}$; $\overline{Q}_{L,n-1}$, $Q_{LR}$, $\overline{Q}_{LR}$) ferner umfaßt:

Schmelzeinsätze ($F_{10}$, $\overline{F}_{10}$, ... $F_{1, n-1}$, $\overline{F}_{1, \overline{n}-1}$, $F_{1R}$, $\overline{F}_{1R}$), die zwischen den genannten Auswahlleitungseinrichtungen und den genannten Transistoren verbunden sind; und

eine Schmelzeinrichtung zum Schmelzen der genannten Schmelzeinsätze, die mit einer der genannten Auswahlleitungseinrichtungen ($B_0$, $\overline{B}_0$, ..., $B_{n-1}$, $\overline{B}_{n-1}$) verbindbar sind, die mit einer oder mehreren defekten Speicherzellen verbunden sind.

5. Vorrichtung nach Anspruch 1, 2 oder 3, bei der die genannten Verbindungs/Trenn-Einrichtungen ($Q_{L0}$, $\overline{Q}_{L0}$; ... $Q_{L,n-1}$; $\overline{Q}_{L,n-1}$, $Q_{LR}$, $\overline{Q}_{LR}$) ferner umfassen:

Schmelzeinsätze ($F_{20}$, $F_{21}$, ...$F_{2, n-1}$, $F_{2R}$), die zwischen der genannten Energieversorgungseinrichtung ($V_{CC}$) und den genannten Transistoren verbunden sind; und

eine Schmelzeinrichtung zum Schmelzen der genannten Schmelzeinsätze, die mit einer der genannten Auswahleinrichtungen ($B_0$, $\overline{B}_0$, ..., $B_{n-1}$, $\overline{B}_{n-1}$) verbindbar sind, die mit einer oder mehreren defekten Speicherzellen verbunden ist.

6. Vorrichtung nach einem der vorhergehenden Ansprüche, bei der jede der genannten Auswahlleitungseinrichtungen ($B_0$, $\overline{B}_0$; $B_1$, $\overline{B}_1$;... $B_{n-1}$, $\overline{B}_{n-1}$; $B_R$, $\overline{B}_R$) ein Paar von Bitleitungen umfaßt.

EP 0 121 394 B1

Fig. I

| Fig. IA | Fig. IB |

Fig.IA

COLUMN ADDRESS DECODERS

ROW ADDRESS DECODERS

8

Fig. 1B

9

# Fig. 2

# Fig. 4A

# Fig. 4B

# Fig. 5

Fig. 3

| Fig. 3A | Fig. 3B |

# Fig. 3A

EP 0 121 394 B1

Fig. 3B

12

## Fig. 6A

SELECTED STATE

$\overline{CS}$

## Fig. 6B

ADD

## Fig. 6C

$\phi$

## Fig. 7

PG

$A_0$ → PG$_0$

$A_1$ → PG$_1$

$A_{l-1}$ → PG$_{l-1}$

$\overline{CS}$ → PG$_l$

OR → $\phi$

Fig. 8

Fig. 9A

Fig. 9B

Fig. 9C

Fig. 9D

Fig. 9E

Fig. 9F

Fig. 9G

Fig. 9H

Fig.10

| Fig.10A | Fig.10B |

Fig.10A

COLUMN ADDRESS DECODERS

Fig.IOB

*Fig.11*

| Fig.11A | Fig.11B |

*Fig.11A*

COLUMN ADDRESS DECODERS

EP 0 121 394 B1

*Fig. 11B*

18